# EUROPEAN PATENT APPLICATION

(11) **EP 1 643 819 A2**
(43) Date of publication of application: **05.04.2006**
(21) Application number: 05255962.2
(22) Date of filing: 26.09.2005
(51) Int. Cl.: H05K 3/40

(54) **Method of manufacturing a substrate with through electrodes**

(30) Priority: 01.10.2004 JP 2004290142
(71) Applicant: SHINKO ELECTRIC INDUSTRIES CO., LTD., Nagano-shi, Nagano 381-2287 (JP)
(72) Inventor: Koizumi, Naoyuki Shinko Electric Ind. co., Ltd., Nagano-shi Nagano 381-2287 (JP); Shiraishi, Akinori Shinko Electric Ind. co., Ltd., Nagano-shi Nagano 381-2287 (JP)
(74) Representative: Fenlon, Christine Lesley

(57) **Abstract**

A method of manufacturing a substrate with through electrodes of the present invention, includes the steps of forming a metal post (18a) over a temporal substrate (10) in a state that the metal post is peelable from the temporal substrate (10), placing a normal substrate (20) in which a through hole (20x) is provided in a position corresponding to the metal post (18a) over the temporal substrate (10), whereby inserting the metal post (18a) on the temporal substrate (10) into the through hole (20x) in the normal substrate (20), and obtaining a through electrode (18) that is formed of the metal post (18a) passing through the normal substrate (20) by peeling the temporal substrate (10) from the metal post (18a).

## Description

### BACKGROUND OF THE INVENTION

### 1. Field of the Invention

The present invention relates to a method of manufacturing a substrate with through electrodes and, more particularly, a method of manufacturing a substrate with through electrodes having such a structure that upper and lower sides of the substrate can be connected electrically via the through electrodes passing through the substrate in a thickness direction.

### 2. Description of the Related Art

In the prior art, there is provided a substrate with through electrodes having the structure in which the through electrodes are formed in the substrate along a thickness direction to connect electrically upper and lower sides of the substrate. In Patent Literature 1 (Patent Application Publication (KOKAI) Hei 7-73920), there is recited a method of manufacturing an electrical connecting device having such a structure that conductors passing through a resin film are formed by making bump conductors formed on a supporting sheet or a copper foil pass through the resin film.

Also, in Patent Literature 2 (Patent Application Publication (KOKAI) Hei 7-231163) and Patent Literature 3 (Patent Application Publication (KOKAI) Hei 6-342977), there is recited a method of inserting conductive bumps into a synthetic resin sheet along a thickness direction by forming the conductive bumps on the synthetic resin sheet, then placing a wear plate on upper and lower sides respectively, and then heating/pressurizing them.

By the way, recently a substrate with through electrodes having such a structure that the through electrodes are formed in a semiconductor substrate (silicon, or the like) has been developed. Such substrate with through electrodes is arranged between a circuit substrate and a semiconductor chip to be packaged on this board, for example, and the semiconductor chip is connected electrically to the circuit substrate via the substrate with through electrodes. Alternately, there are some cases where the through electrodes are provided in the semiconductor substrates so as to stack and connect electrically semiconductor substrates on which semiconductor elements are formed.

As the first method of manufacturing such substrate with through electrodes, first a semiconductor substrate in which through holes are formed is covered with an insulating layer, and then a metallic foil is pasted on a bottom surface of the semiconductor substrate. Then, through electrodes are formed in the through holes by the electroplating using the metallic foil as the plating power-supply layer, and then the through electrodes are obtained by removing the metallic foil.

Also, as the second method of manufacturing such substrate, first blind vias which do not pass through the substrate are formed in a semiconductor substrate, and also an insulating layer is formed on a surface of the semiconductor substrate by oxidizing the substrate. Then, a seed layer is formed on the upper surface of the semiconductor substrate by the CVD method, and also a metal layer is formed by the electroplating to fill the blind vias. Then, the metal layer on the lower side of the blind vias is exposed by grinding the semiconductor substrate from the back surface side, and then the through electrodes are obtained by removing the metal layer on the upper side of the silicon substrate.

However, in the first method of manufacturing such substrate, such a problem exists that heights of the through electrodes are varied in the substrate upon forming the through electrodes by the electroplating. A method of grinding top portions of the through electrodes by the polishing, or the like to planarize them may be considered. In this case, when semiconductor elements are formed on the semiconductor substrate, there is a possibility that such semiconductor elements are damaged.

Also, in the second method of manufacturing such substrate, a seed layer must be formed on one surface of a thin semiconductor substrate (e.g., almost 200 µm or less) by the CVD method at a relatively high temperature (350°C or more). Therefore, it is possible that such annealing causes a warp of the semiconductor substrate or inflicts damage on the semiconductor elements.

In this event, according to the manufacturing methods in above Patent Literatures 1 to 3, it is difficult to form the through electrodes in the semiconductor substrate.

### SUMMARY OF THE INVENTION

It is desirable to provide a method of manufacturing a substrate with through electrodes, capable of forming the through electrodes in a semiconductor substrate, or the like not to cause any defect.

According to an embodiment of the present invention there is provided a method of manufacturing a substrate with through electrodes, which comprises the steps of forming a metal post over a temporal substrate in a state that the metal post can be peeled from the temporal substrate, placing a normal substrate in which a through hole is provided in a position corresponding to the metal post over the temporal substrate, whereby inserting the metal post on the temporal substrate into the through hole in the normal substrate, and obtaining a through electrode which is formed of the metal post passing through the normal substrate by peeling the temporal substrate from the metal post.

In one preferred mode of the present invention, the peelable layer and the seed metal layer (metallic foil) are formed in sequence on the temporal substrate, and the metal post is formed on the seed metal layer by the electroplating. Then, the normal substrate (such as the semiconductor substrate on an overall surface of which an insulating layer is formed, or the like) in which the through hole is provided in a position corresponding to the metal post is positioned over the temporal substrate, and then the metal post is inserted into the through hole of the normal substrate. Then, the temporal substrate is peeled along an interface between the peelable layer and the seed metal layer, and then the seed metal layer is removed or the seed metal layer is patterned to be connected to the through electrode. The normal substrate (semiconductor substrate) in which the through electrode is formed may be formed of an element substrate on which the semiconductor elements are formed or a simple substrate on which no semiconductor element is formed.

In this way, in the preferred mode of the present embodiment, the metal post is formed on the seed metal layer formed on the temporal substrate via the peelable layer, then the metal post is inserted into the through hole in the normal substrate, and then the temporal substrate is peeled and abandoned. By employing such method, there is no need to form the seed metal layer on the semiconductor substrate, in which the through electrodes are formed, by the CVD including the annealing, and thus the semiconductor substrate can be kept at a room temperature. As a result, such a problem can be avoided that a warp of the thin semiconductor substrate is generated or the semiconductor elements formed on the semiconductor substrate are damaged.

Also, since the metal post is formed previously on the temporal substrate, there is no need to form directly the metal post in the through hole in the semiconductor substrate by the electroplating. Therefore, a reduction in a time and labor required in the manufacturing method can be achieved.

In addition, even when heights of the metal posts are varied, the leveling can be applied by polishing the upper portions of the metal posts on the temporal substrate, or the like. Therefore, in case the semiconductor elements are formed on the semiconductor substrate, such semiconductor elements are not damaged upon leveling the metal post.

The substrate with through electrodes of the present invention may be employed as the interposer that aligns the semiconductor chip with the circuit substrate by providing the through electrode in the semiconductor substrate, or a structure in which a plurality of semiconductor devices are stacked three-dimensionally and are connected mutually via the through electrode by providing the through electrode in the semiconductor substrate on which the semiconductor elements are formed. Otherwise, the substrate with through electrodes of the present invention may be applied to the packaging substrate in which the movable portion of the MEMS device is fit in the recess portion and packaged by providing the recess portion in the major center portion of the substrate with through electrodes.

### BRIEF DECRIPTION OF THE DRAWINGS

FIGS.1A to 1L are sectional views showing a method of manufacturing a substrate with through electrodes according to a first embodiment of the present invention;
FIG.2 is a sectional view showing an example in which the substrate with through electrodes according to the first embodiment of the present invention is applied to an interposer;
FIG.3 is a sectional view showing an example in which semiconductor devices to which the substrate with through electrodes according to the first embodiment of the present invention is applied are stacked three-dimensionally and connected mutually;
FIGS.4A to 4F are sectional views showing a method of manufacturing a substrate with through electrodes according to a second embodiment of the present invention;
FIG.5 is a sectional view showing an example in which the substrate with through electrodes according to the second embodiment of the present invention is applied to a MEMS device packaging substrate; and
FIG.6 is a sectional view showing a method of forming metal posts in the method of manufacturing a substrate with through electrodes according to another embodiment of the present invention.

### DETAILED DESCRIPTION OF THE PREFERRED EMBODIMENTS

Embodiments of the present invention will be explained with reference to the accompanying drawings hereinafter.

### (First Embodiment)

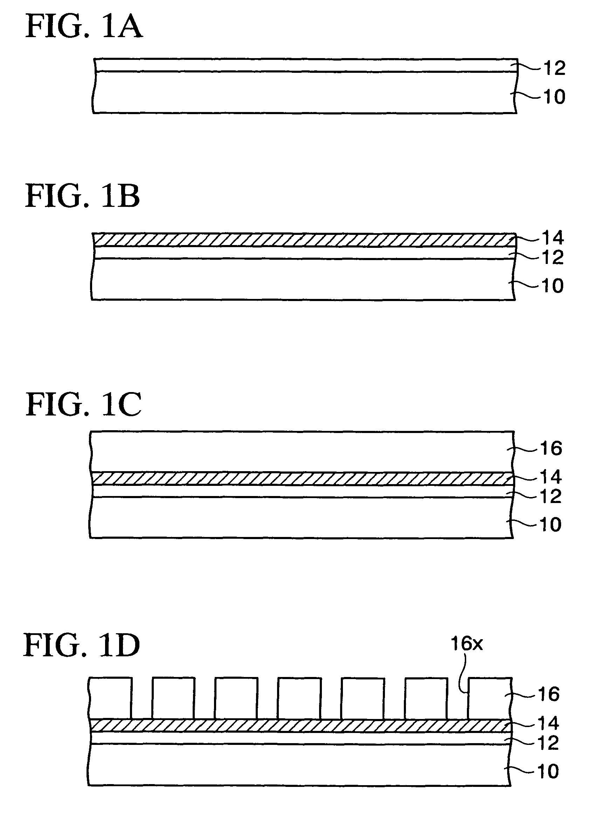

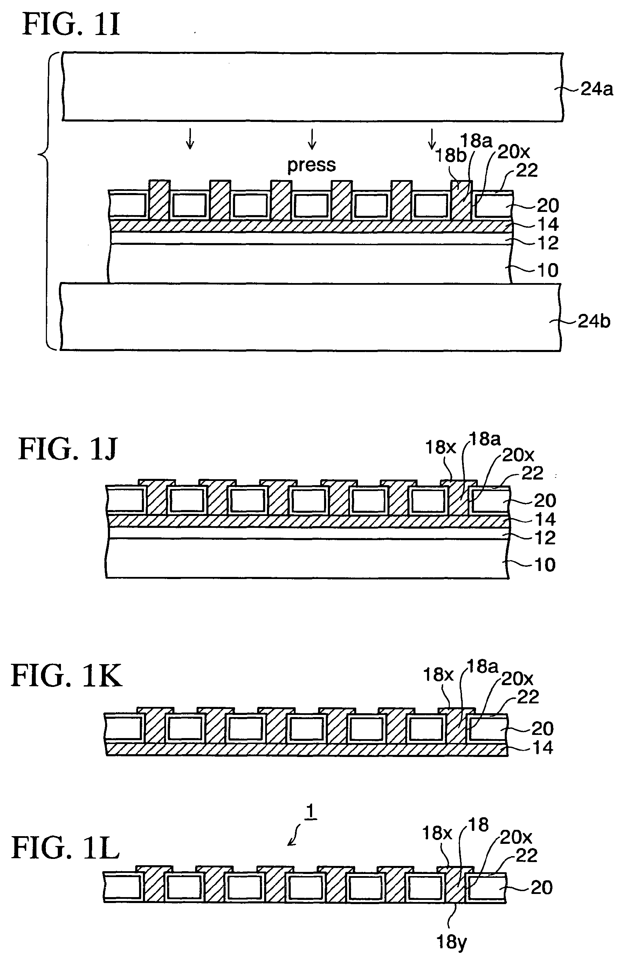

FIGS.1A to 1L are sectional views showing a method of manufacturing a substrate with through electrodes according to a first embodiment of the present invention in sequence. In the method of manufacturing the substrate with through electrodes in the first embodiment, as shown in FIG.1A, first a temporal substrate 10 is prepared, and a peelable layer 12 is formed on the temporal substrate 10. As the temporal substrate 10, a semiconductor substrate (a silicon wafer, a silicon chip, or the like) is used preferably. As the peelable layer 12, a heat peeled tape having such a characteristic that can be pasted onto a seed metal layer formed on the temporal substrate 10 and the peelable layer 12 at an ordinary temperature but can be peeled from an interface of the seed metal layer by applying heat is used preferably.

Then, as shown in FIG.1B, a seed metal layer 14 is formed on the peelable layer 12. As the seed metal layer 14, a metallic foil made of copper (Cu), or the like is used preferably, and pasted onto the peelable layer 12. Then, as shown in FIG.1C, a resist film 16 is formed on the seed metal layer 14. As the method of forming the resist film 16, a resist coating liquid may be formed by the spin coating, or the like, or a dry film resist may be pasted.

Then, as shown in FIG.1D, opening portions 16x are formed in the resist film 16 by exposing/developing the resist film 16.

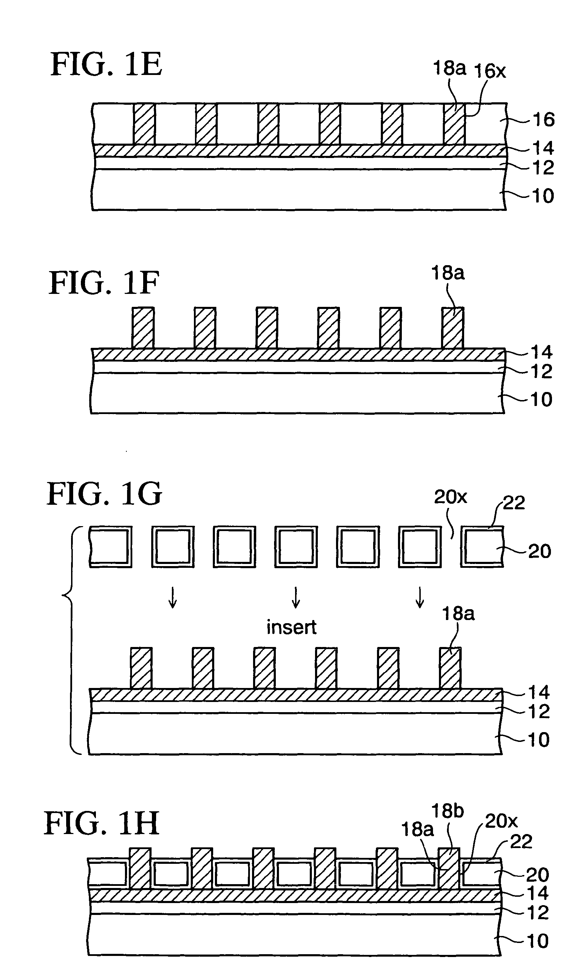

Then, as shown in FIG.1E, metal posts 18a made of Cu, or the like are formed in the opening portions 16x in the resist film 16 by the electroplating utilizing the seed metal layer 14 as the plating power-supply layer. Then, the resist film 16 is removed by the remover or the dry ashing. Thus, as shown in FIG.1F, the metal posts 18a provided to stand upright on the seed metal layer 14 formed on the temporal substrate 10 are exposed. The metal posts 18a act later as the through electrodes that are provided to pass through the semiconductor substrate.

In the case where a variation in heights of the metal posts 18a become a problem, top portions of the metal posts 18a may be polished by the CMP, or the like after the step in FIG.1E (before the resist film 16 is removed). Thus, a variation in heights can be reduced by leveling the metal posts 18a. In this case, since no semiconductor element is formed on the temporal substrate 10, there is no possibility that such polishing causes damage on the semiconductor elements.

Then, as shown in FIG.1G, a semiconductor substrate 20 (a silicon wafer, a silicon chip, or the like whose thickness is 200 µm or less, for example) in which through holes 20x are formed is prepared as a normal substrate in which the through electrodes are formed. Then, an insulating layer 22 formed of a silicon oxide layer is formed on both surfaces of the semiconductor substrate 20 and inner surfaces of the through holes 20x by thermally oxidizing the semiconductor substrate 20. The through holes 20x in the semiconductor substrate 20 are formed by the dry etching (RIE, or the like) using the resist film as a mask, in which opening portions are provided on the semiconductor substrate 20. Also, the through holes 20x in the semiconductor substrate 20 are formed in positions that correspond to the metal posts 18a formed on the temporal substrate 10. The semiconductor substrate 20 may be formed of an element substrate on which the semiconductor elements, etc. are formed or a simple substrate on which no semiconductor element is formed.

Then, as also shown in FIG.1G, the semiconductor substrate 20 is positioned over the temporal substrate 10 in a condition that the through holes 20x in the semiconductor substrate 20 are aligned to correspond to the metal posts 18a formed on the temporal substrate 10. Thus, as shown in FIG.1H, the metal posts 18a are inserted into the through holes 20x in the semiconductor substrate 20. At this time, because a thickness of the semiconductor substrate 20 is set thinner than the height of the metal posts 18a, the metal posts 18a are inserted into the through holes 20x in the semiconductor substrate 20 to have projection portions 18b that are projected from the upper surface of the semiconductor substrate 20.

Then, as shown in FIG.1I, a resultant structure in FIG.1H is placed on a lower die 24b, and then the projection portions 18b of the metal posts 18a projected from the upper surface of the semiconductor substrate 20 are crashed by pressing the resultant structure by means of an upper die 24a. Thus, as shown in FIG.1J, the projection portions 18b of the metal posts 18a are extended in the lateral direction, and thus upper connection portions 18x are formed. In addition, since the metal posts 18a in the through holes 20x in the semiconductor substrate 20 are extended in the lateral direction, clearances between the through holes 20x and the metal posts 18a are filled, whereby the metal posts 18a are fixed in the through holes 20x in the semiconductor substrate 20.

Then, as shown in FIG.1K, the temporal substrate 10 is peeled along an interface between the peelable layer 12 and the seed metal layer 14 by annealing the resultant structure at a temperature of 100 to 200°C. Then, the temporal substrate 10 onto which the peelable layer 12 is pasted is abandoned.

Then, as shown in FIG.1L, the seed metal layer 14 is removed selectively from a resultant structure in FIG.1K. This seed metal layer 14 is removed by the wet etching or the polishing.

In this fashion, the metal posts 18a formed on the temporal substrate 10 act as through electrodes 18 provided in the through holes 20x in the semiconductor substrate 20, and also lower connection portions 18y are exposed on bottom portions of the through electrodes 18. Accordingly, a substrate 1 with through electrodes of the present embodiment can be obtained.

In the above embodiment, the seed metal layer 14 is removed. But wiring patterns connected to the through electrodes 18 may be formed on the lower surface of the semiconductor substrate 20 as the lower connection portions, by patterning the seed metal layer 14 by means of the photolithography and the etching.

As explained above, according to the method of manufacturing the substrate with through electrodes of the present embodiment, first the peelable layer 12 and the seed metal layer 14 are formed on the temporal substrate 10, and then the resist film 16 in which the opening portions 16x are provided in predetermined portions is formed on the seed metal layer 14. Then, the metal posts 18a are formed in the opening portions 16x in the resist film 16 by the electroplating using the seed metal layer 14 as the plating power-supply layer, and then the resist film 16 is removed.

Then, the semiconductor substrate 20 in which the through holes 20x are provided in the portions corresponding to the metal posts 18a and an overall surface of which is covered with the insulating layer 22 is prepared. Then, the semiconductor substrate 20 is arranged over the temporal substrate 10, and then the metal posts 18a are inserted into the through holes 20x in the semiconductor substrate 20. Then, the projection portions 18b of the metal posts 18a projected from the upper surface of the semiconductor substrate 20 are crashed by the press, so that the upper connection portions 18x are formed and simultaneously the metal posts 18a are fixed in the metal posts 18a.

Then, the temporal substrate 10 is peeled along an interface between the peelable layer 12 and the seed metal layer 14, then the temporal substrate 10 on which the peelable layer 12 is pasted is abandoned, and then the seed metal layer 14 is removed. Accordingly, the bottom surfaces of the metal posts 18a are exposed, and the metal posts 18a constitute the through electrodes 18 that pass through the semiconductor substrate 20. Then, the upper and lower sides of the through electrodes 18 constitute the upper connection portions 18x and the lower connection portions 18y respectively. In this manner, the through electrodes 18 that can connect electrically the upper and lower sides of the semiconductor substrate 20 are formed in the through holes 20x in the semiconductor substrate 20. A plurality of through electrodes 18 are insulated electrically by the insulating layer 22 that is formed on both surfaces of the semiconductor substrate 20 and the inner surfaces of the through holes 20x.

In this way, in the present embodiment, the metal posts 18a are formed by the electroplating using the seed metal layer 14 formed on the temporal substrate 10 as the plating power-supply layer. Therefore, there is no need to form the seed metal layer on the semiconductor substrate 20, into which the through electrodes 18 are inserted, by the CVD including the annealing, and thus the semiconductor substrate 20 can be maintained at a room temperature. As a result, there is no possibility that a warp of the thin semiconductor substrate 20 is generated. In addition, even when the semiconductor elements are formed on the semiconductor substrate 20, the annealing is not applied to the semiconductor substrate 20. As a result, there is no possibility that the semiconductor elements are damaged.

Further, even when a variation in heights of the metal posts 18a is reduced by leveling the metal posts 18a after the step in FIG.1H, the semiconductor elements are not formed on the temporal substrate 10. Therefore, it is not possible that the semiconductor elements are damaged, and various leveling methods can be employed.

Besides, the step of forming the metal posts 18a in the opening portions 16x of the resist film 16 by the electroplating needs a relatively long time. In this case, if the metal posts 18a are formed previously on the temporal substrate 10, a time and labor required to form the through electrodes 18 in the semiconductor substrate 20 can be shortened, and also a reduction of an delivery date of a product can be achieved.

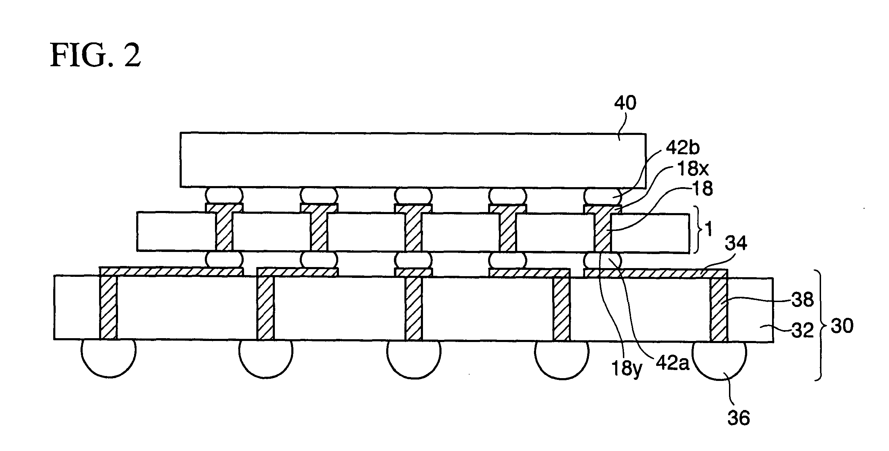

In FIG.2, an example in which the substrate 1 with through electrodes of the first embodiment of the present invention is applied to an interposer that aligns the semiconductor chip with the circuit substrate is shown.

As shown in FIG.2, in a circuit substrate 30, via posts 38 are provided in a resin substrate 32 to pass through, and wiring patterns 34 formed on an upper surface of the resin substrate 32 are connected to external connection terminals 36, which are formed on the lower surface side of the resin substrate 32, via the via posts 38.

Then, the lower connection portions 18y of the through electrodes 18 of the substrate 1 with through electrodes of the present embodiment are connected to the wiring patterns 34 of the circuit substrate 30 via bumps 42a. Then, a semiconductor chip 40 is connected to the upper connection portions 18x of the through electrodes 18 of the substrate 1 with through electrodes via bumps 42b.

In this manner, the substrate 1 with through electrodes of the present embodiment is arranged between the circuit substrate 30 and the semiconductor chip 40 (CPU, or the like), and the terminals of the semiconductor chip 40 are connected electrically to the terminals of the circuit substrate 30 with alignment or grid conversion.

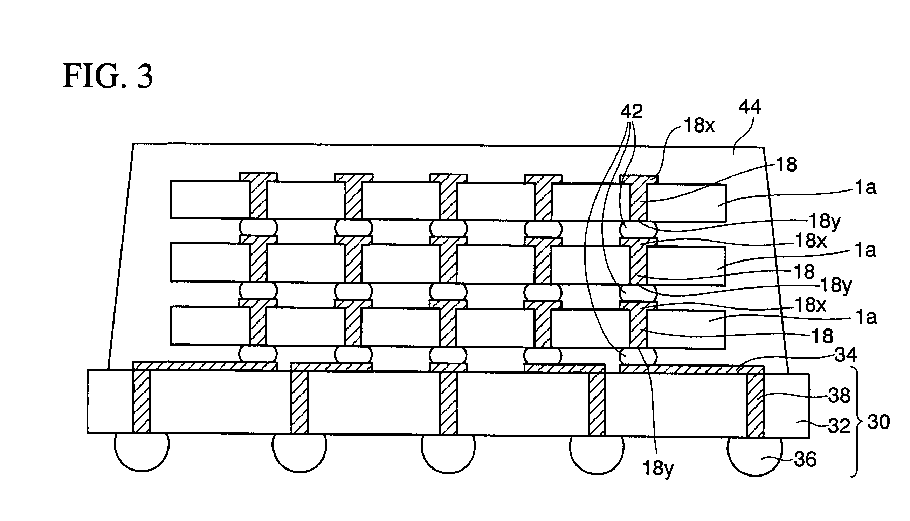

Also, as shown in FIG.3, as the substrate with through electrodes embodying the present invention, a semiconductor element substrate 1a with through electrodes (semiconductor chip, or the like) on which the semiconductor elements, and the like are formed may be employed. More particularly, a plurality of semiconductor element substrates 1a with through electrodes of the present embodiment are stacked three-dimensionally and packaged onto the similar circuit substrate 30 to that in FIG.2, and the through electrodes 18 are connected to the wiring patterns 34 of the circuit substrate 30 respectively in a condition that such through electrodes 18 are connected mutually via bumps 42. Then, a plurality of semiconductor element substrates 1a with through electrodes are sealed with a sealing resin 44.

If doing so, wiring lengths between a plurality of semiconductor element substrates can be shortened. Therefore, the present embodiment can deal with an increase in an operating frequency and also the chip laminated type module responding to the high density packaging can be manufactured at a low cost with a high yield.

### (Second Embodiment)

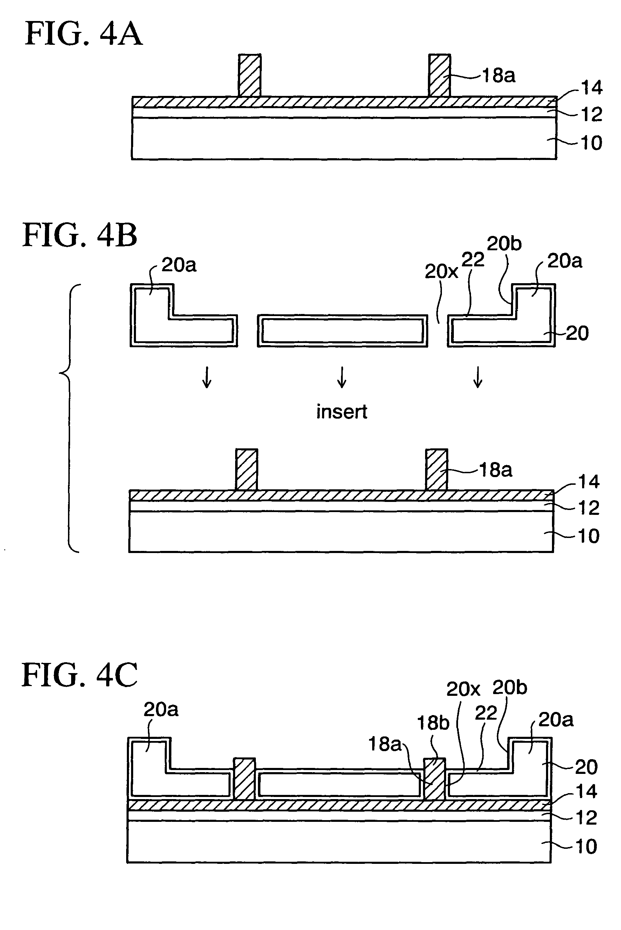

FIGS.4A to 4F are sectional views showing a method of manufacturing a substrate with through electrodes according to a second embodiment of the present invention. In the second embodiment, such a mode is shown that the substrate with through electrodes of the present invention is applied to the MEMS (Micro Electro Mechanical Systems) device packaging substrate (silicon cap).

In the method of manufacturing the substrate with through electrodes of the second embodiment, as shown in FIG.4A, first the peelable layer 12 and the seed metal layer 14 are formed on the temporal substrate 10 by the same method as the first embodiment, and the metal posts 18a which stand upright are formed on the seed metal layer 14. Then, as shown in FIG.4B, the semiconductor substrate 20 in which the through holes 20x are provided is prepared, and then the insulating layer 22 is formed on both surfaces of the semiconductor substrate 20 and inner surfaces of the through holes 20x. In the second embodiment, a substrate having such a structure that a projection portion 20a is formed on a peripheral portion of the substrate by providing a recess portion 20b in a major center portion is used as the semiconductor substrate 20.

Then, as also shown in FIG.4B, the semiconductor substrate 20 is positioned over the temporal substrate 10 to direct upwardly its surface on which the projection portion 20a of the semiconductor substrate 20 is provided in a condition that the through holes 20x in the semiconductor substrate 20 are aligned with the metal posts 18a on the temporal substrate 10. Thus, as shown in FIG.4C, the metal posts 18a on the temporal substrate 10 are inserted into the through holes 20x in the semiconductor substrate 20 to have the projection portions 18b.

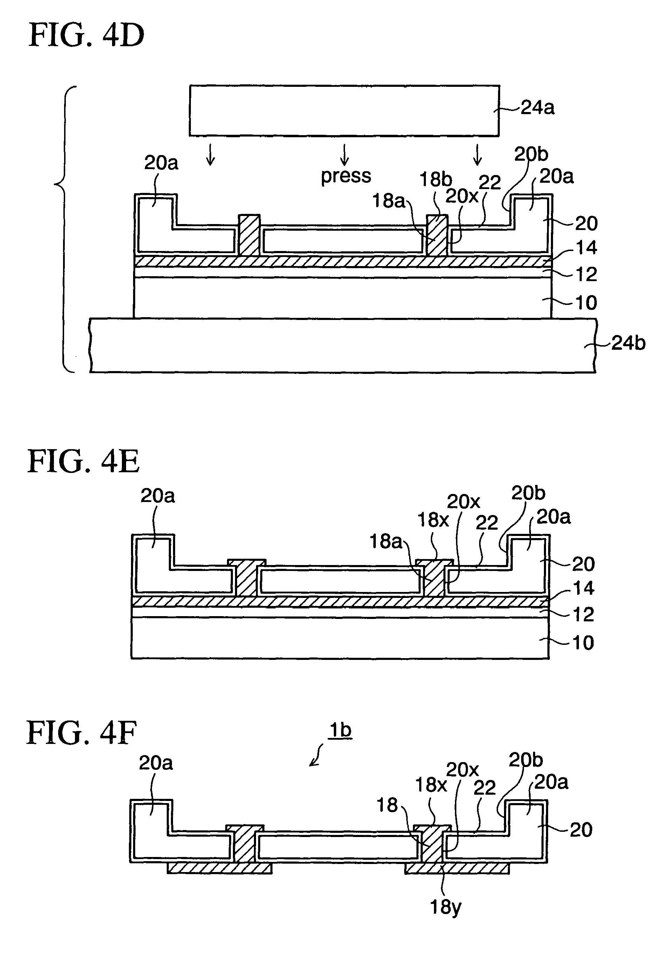

Then, as shown in FIG.4D, like the first embodiment, the resultant structure in FIG.4C is put between the upper die 24a and the lower die 24b and pressed (pressurized). Thus, as shown in FIG.4E, the projection portions 18b of the metal posts 18a projected from the upper surface of the semiconductor substrate 20 are crashed, so that the upper connection portions 18x are formed and at the same time the metal posts 18a are fixed in the through holes 20x in the semiconductor substrate 20.

Then, as shown in FIG.4F, like the first embodiment, the temporal substrate 10 on which the peelable layer 12 is pasted is abandoned by peeling the temporal substrate 10 along an interface between the peelable layer 12 and the seed metal layer 14. Then, the seed metal layer 14 on the lower surface of the semiconductor substrate 20 is patterned by the photolithography and the etching. Accordingly, the metal posts 18a are shaped into the through electrodes 18 and also the lower connection portions 18y connected to the through electrodes 18 are formed under the through electrodes 18.

With the above, a substrate 1b with through electrodes according to the second embodiment can be obtained.

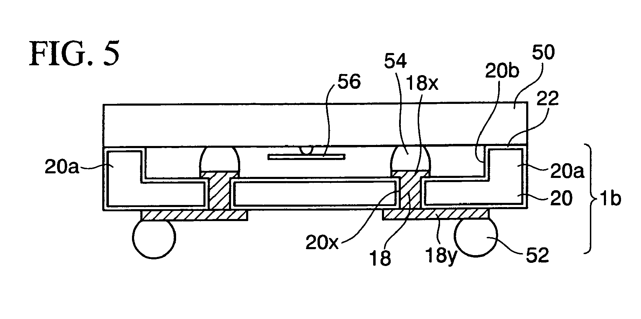

In the substrate 1b with through electrodes of the second embodiment, as shown in FIG.5, external connection terminals 52 are provided to the lower connection portions 18y of the through electrodes 18. Then, a MEMS device 50 (acceleration sensor) having a movable portion 56 is prepared, and connection portions (not shown) of the MEMS device 50 are connected to the upper connection portions 18x of the through electrodes 18 via bumps 54. The MEMS device 50 can be manufactured by the micromachining technology, and also a pressure sensor, a switch, or the like may be employed in addition to the acceleration sensor. In this way, the movable portion 56 of the MEMS device 50 is fit in the recess portion 20b (cavity) of the substrate 1a with through electrodes in packaging.

According to the method of manufacturing the substrate with through electrodes of the second embodiment, the advantages similar to the first embodiment can be achieved and also the packaging substrate (silicon cap) for the MEMS device having the movable portion can be easily manufactured.

### (Other Embodiment)

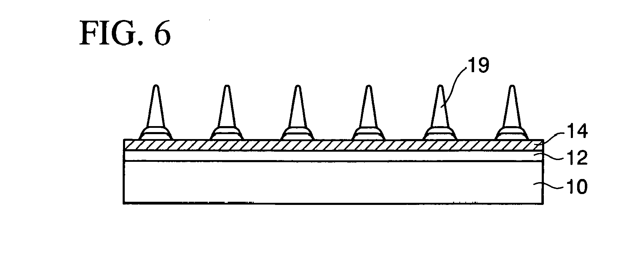

FIG.6 is a sectional view showing a method of forming metal posts in the method of manufacturing a substrate with through electrodes according to other embodiment of the present invention.

In the foregoing first and second embodiments, the metal posts 18a are formed on the seed metal layer 14 on the temporal substrate 10 by the electroplating. In this case, as shown in FIG.6, ball bumps 19 may be formed on the seed metal layer 14 on the temporal substrate 10 by the wire bonding method. In other words, a metal wire made of gold, or the like is pulled out from a capillary of a wire bonder by a predetermined length, then a top end portion of this metal wire is rounded into a spherical shape by the discharge, then the spherical top end portion of the metal wire is brought into contact with the seed metal layer 14 by bringing down the capillary, and then such top end portion is bonded to the seed metal layer 14 by applying the heat and the ultrasonic vibration. Then, the metal wire is torn off by fixing the metal wire by a clamper, while pulling up the capillary. The ball bumps 19 shown in FIG.6 are formed by carrying out these steps plural times. Since later steps are similar to those in the first and second embodiments, their explanation will be omitted herein.

## Claims

1. A method of manufacturing a substrate with through electrodes, comprising the steps of:
forming a metal post (18a) over a temporal substrate (10) in a state that the metal post can be peeled from the temporal substrate (10);
placing a normal substrate (20), in which a through hole (20x) is provided in a position corresponding to the metal post (18a), over the temporal substrate (10), whereby inserting the metal post (18a) on the temporal substrate (10) into the through hole (20x) in the normal substrate (20); and
obtaining a through electrode (18), which is formed of the metal post (18a) passing through the normal substrate (20), by peeling the temporal substrate (10) from the metal post (18a).

2. A method of manufacturing a substrate with through electrodes, according to claim 1, wherein a peelable layer (12) and a seed metal layer (14) are formed in sequence on the temporal substrate (10),
the step of forming the metal post (18a) is a step of forming the metal post (18a) in a predetermined portion by an electroplating using the seed metal layer (14) as a plating power-supply layer, and
the step of obtaining the through electrode (18) includes
a step of peeling the temporal substrate (10) from the metal post (18a) along an interface between the peelable layer (12) and the seed metal layer (14), and
a step of removing the seed metal layer (14), or patterning the seed metal layer (14) to be connected to the through electrode (18).

3. A method of manufacturing a substrate with through electrodes, according to claim 1 or 2, wherein, in the step of inserting the metal post (18a) into the through hole (20x) in the normal substrate (20), the metal post (18a) is inserted to provide a projection portion (18b) that is projected from an upper surface of the normal substrate (20), and
further comprising:
a step of crashing the projection portion (18b) by a press to form an upper connection portion (18x) of the through electrode (18) and also fix the through electrode (18) in the through hole (20x), before the step of peeling the temporal substrate (10).

4. A method of manufacturing a substrate with through electrodes, according to claim 1, 2 or 3, wherein the normal substrate (20) has such a structure that a projection portion (20a) is provided on a peripheral portion by providing a recess portion (20b) in a major center portion, and the through hole (20x) is provided in an area in which the recess portion (20b) is formed, and
in the step of inserting the metal post (18a) into the through hole (20x) in the normal substrate (20), the normal substrate (20) is positioned over the temporal substrate (10) to direct upwardly a surface of the normal substrate (20) on which the projection portion (20a) is provided.

5. A method of manufacturing a substrate with through electrodes, according to any preceding claim, wherein the temporal substrate (10) is formed of a semiconductor substrate, the normal substrate (20) is formed of a semiconductor substrate in which an insulating layer (22) is formed on both surfaces and an inner surface of the through hole (20x), and the seed metal layer (14) is formed of a metallic foil.

6. A method of manufacturing a substrate with through electrodes, according to claim 5, wherein a semiconductor element is formed on the normal substrate (20).

7. A method of manufacturing a substrate with through electrodes, according to claim 1, wherein a peelable layer (12) and a seed metal layer (14) are formed on the temporal substrate (10),
the step of forming the metal post (18a) is a step of forming a ball bump (19) on the seed metal layer (14) by a wire bonding method, and
the step of obtaining the through electrode (18) includes
a step of peeling the temporal substrate (10) from the metal post (18a) along an interface between the peelable layer (12) and the seed metal layer (14), and
a step of removing the seed metal layer (14) or patterning the seed metal layer (14) to be connected to the through electrode (18).

8. A method of manufacturing a substrate with through electrodes, according to claim 5, wherein the semiconductor is made of silicon, and the seed metal layer (14) and the metal post (18a) are made of copper.
